# EUROPEAN PATENT APPLICATION

(11) **EP 4 535 932 A1**
(43) Date of publication of application: **09.04.2025**
(21) Application number: 23829376.5
(22) Date of filing: 29.01.2023
(51) Int. Cl.: H05K 1/11

(54) **VIA HOLE STRUCTURE OF CIRCUIT BOARD, AND CIRCUIT BOARD**

(30) Priority: 30.06.2022 CN 202210769999
(71) Applicant: ZTE CORPORATION, Shenzhen, Guangdong 518057 (CN)
(72) Inventor: REN, Xiaoying, Shenzhen, Guangdong 518057 (CN); LI, Jinlong, Shenzhen, Guangdong 518057 (CN); WEI, Zhongmin, Shenzhen, Guangdong 518057 (CN); KANG, Xin, Shenzhen, Guangdong 518057 (CN)
(74) Representative: Ziebig Hengelhaupt Intellectual Property Attorneys Patentanwaltskanzlei PartGmbB
(86) International application number: PCT/CN2023/073714
(87) International publication number: WO 2024/001183

(57) **Abstract**

Provided in the present disclosure are a via hole structure of a circuit board, and a circuit board. The via hole structure comprises at least one pair of differential signal holes, wherein each pair of differential signal holes comprises a first differential signal hole and a second differential signal hole. In a thickness direction of a circuit board, there are several distances between the central axis of the first differential signal hole and the central axis of the second differential signal hole, and numerical values of at least two distances are different.

## Description

### CROSS-REFERENCE TO RELATED APPLICATIONS

The present disclosure claims priority to the Chinese patent application No. CN202210769999.0 filed on June 30, 2022 and entitled "VIA HOLE STRUCTURE OF CIRCUIT BOARD, AND CIRCUIT BOARD", the entire content of which is incorporated herein by reference.

### TECHNICAL FIELD

The present disclosure relates to the field of communications, and in particular to a via hole structure of a circuit board, and a circuit board.

### BACKGROUND

Compared with single-ended signals, differential signals are often used to propagate signals in the industry because of their superior high gain and robustness. In different systems, differential via holes on a circuit board play a crucial role in realizing differential signal interconnection of high-speed connectors, ball grid arrays and other components in the systems.

In many high-speed systems, due to the processing limitations of a product, the differential via hole impedance at the connection between the product and the high-speed multi-layer circuit board deviates from the system impedance, causing multiple impedance discontinuities, resulting in a sharp deterioration of signal quality, and signal integrity problems, and in severe cases, the systems cannot be used normally. Therefore, at present, multi-layer circuit boards have a problem of poor impedance continuity.

### SUMMARY

The present disclosure provides a via hole structure of a circuit board, and a circuit board, so as to at least solve the problem of poor impedance continuity of multi-layer circuit boards in the related art.

According to an embodiment of the present disclosure, a via hole structure of a circuit board is provided, and includes at least one pair of differential signal holes. Each pair of differential signal holes includes a first differential signal hole and a second differential signal hole. In a thickness direction of the circuit board, there are several distances between a central axis of the first differential signal hole and a central axis of the second differential signal hole, and numerical values of at least two distances are different.

In an exemplary embodiment, an aperture of each first signal aperture segment is completely the same, partially the same or completely different; and an aperture of each second signal aperture segment is completely the same, partially the same or completely different.

According to another embodiment of the present disclosure, a circuit board is provided, and includes the via hole structure of the circuit board according to the above-mentioned embodiment.

### BRIEF DESCRIPTION OF DRAWINGS

The accompanying drawings are included here to provide a further understanding of the present disclosure and constitute a part of the present disclosure. The exemplary embodiments of the present disclosure and the description thereof are used for explaining the present disclosure and do not constitute inappropriate limitation to the present disclosure. In the figures:
FIG. 1 is a schematic structural diagram (I) of a via hole structure of a circuit board according to the present disclosure;
FIG. 2 is a schematic structural diagram (II) of a via hole structure of a circuit board according to the present disclosure;
FIG. 3 is a schematic structural diagram (III) of a via hole structure of a circuit board according to the present disclosure;
FIG. 4 is a schematic structural diagram (IV) of a via hole structure of a circuit board according to the present disclosure;
FIG. 5 is a schematic structural diagram (V) of a via hole structure of a circuit board according to the present disclosure;
FIG. 6 is a schematic structural diagram (VI) of a via hole structure of a circuit board according to the present disclosure;
FIG. 7 is a schematic structural diagram (VII) of a via hole structure of a circuit board according to the present disclosure;
FIG. 8 is a schematic structural diagram (VIII) of a via hole structure of a circuit board according to the present disclosure; and
FIG. 9 is an impedance comparison diagram after center distances of differential signal holes are decreased according to the present disclosure.

Reference signs:
100a, first differential signal hole; 100b, second differential signal hole; 110a, first signal segment; 120a, second signal segment; 111a, first pad; 121a, second pad; 111b, third pad; 121b, fourth pad; 110b, third signal segment; 120b, fourth signal segment; 130a, first conductor; 130b, second conductor; 200a, first ground via hole; 200b, second ground via hole; 210a, first ground via segment; 220a, second ground via segment; 210b, third ground via segment; 220b, fourth ground via segment; 211a, fifth pad; 221a, sixth pad; 230a, third conductor; 211b, seventh pad; 221b, eighth pad; and 230b, fourth conductor.

### DETAILED DESCRIPTION

The present disclosure will be described in detail below with reference to the accompanying drawings in conjunction with embodiments. It should be noted that the embodiments and features of the embodiments in the present disclosure may be combined with each other without conflict.

It should be noted that the terms "first", "second" and the like in the description, claims and accompanying drawings of the present disclosure are used for distinguishing between similar objects and not necessarily for describing a particular sequential or precedence order.

### Embodiment 1

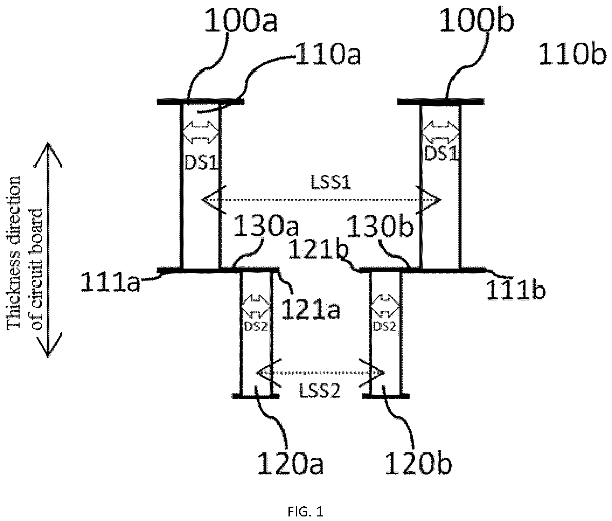

The present embodiment provides a via hole structure of a circuit board. FIG. 1 is a schematic structural diagram (I) of a via hole structure of a circuit board according to the present disclosure. As shown in FIG. 1, the via hole structure of the circuit board includes at least one pair of differential signal holes, the differential signal holes are differential via holes, the differential signal holes are used for transmitting differential signals, each pair of differential signal holes includes a first differential signal hole 100a and a second differential signal hole 100b, and in a thickness direction of the circuit board, there are several distances between the central axis of the first differential signal hole 100a and the central axis of the second differential signal hole 100b, and numerical values of at least two distances are different.

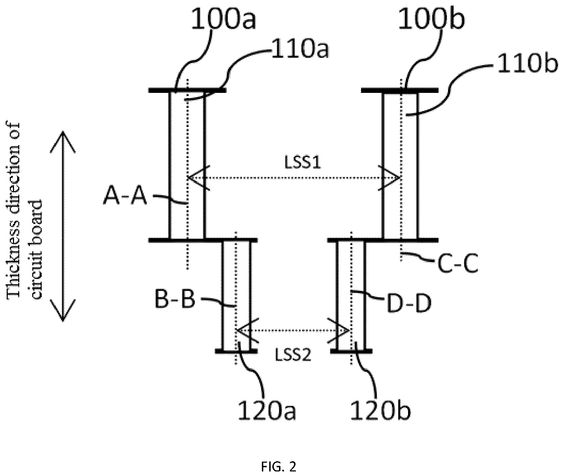

The thickness direction of the circuit board refers to the up and down direction shown in FIG. 1, and there are several distances in the thickness direction of the circuit board, which means that there are several distances between the central axis of the first differential signal hole and the central axis of the second differential signal hole in the up and down direction in the figure, the distances are LSS1, LSS2, LSS3... LSSN respectively, and the distances exist in sequence in the thickness direction of the circuit board, that is, the distances are arranged from top to bottom in sequence. The numerical values of at least two distances in several distances are different, that is, the structures of the first differential signal hole 100a and the second differential signal hole 100b are different, so that the numerical value of at least one distance in the distances is different from the numerical values of other distances. In an exemplary embodiment, in combination with FIG. 2, it can be seen that the figure shows a case of two distances, namely LSS1 and LSS2 respectively, LSS1 and LSS2 exist in sequence between the first differential signal hole 100a and the second differential signal hole 100b in the up and down direction in the figure, and the distances LSS1 and LSS2 are different. Similarly, it can also be understood in FIG. 2 that there are several distances between the central axis of the first differential signal hole 100a and the central axis of the second differential signal hole 100b, the numerical values of some of the plurality of distances are the same and are all LSS1, and the numerical values of the rest are the same and are all LSS2. Through the above arrangement, the parasitic capacitance of the differential signal holes can be adjusted, and then the parasitic inductance of the differential signal holes can be adjusted, so that the impedance of the differential signal holes is changed, so as to perform corresponding adjustment to ensure the impedance continuity of system links according to different system links and improve the propagation quality of the differential signals.

In an exemplary embodiment, the circuit board is a multi-layer circuit board. When the multi-layer circuit board is connected to a product, the product includes a high-speed connector, a ball grid array (BGA) and the like, due to the processing limitations of the product, the differential signal hole impedance at the connection between the product and the multi-layer circuit board deviates from the system impedance, causing a plurality of impedance discontinuities, resulting in a sharp decrease of signal quality and the problem of incomplete signals, and in severe cases, the systems cannot be used normally. The problem of impedance discontinuity is solved by adjusting the via hole structure on the multi-layer circuit board.

In an exemplary embodiment, in the thickness direction of the circuit board, there are several distances between the central axis of the first differential signal hole 100a and the central axis of the second differential signal hole 100b, numerical values of at least two distances are different, and an absolute value of the difference between the two different distances is at least 0.001 mm. In an exemplary embodiment, in order to facilitate processing and the like, the difference between the two different distances may be 0.005 mm.

Referring to FIG. 1, in some embodiments, the first differential signal hole 100a is a through hole provided in the thickness direction of the circuit board, the second differential signal hole 100b is a through hole provided in the circuit board in a first direction, and there is a certain included angle between the first direction and the thickness direction of the circuit board. Therefore, in a sectional view of the circuit board, the first differential signal hole 100a is set vertically, and the second differential signal hole 100b is set at a tilt relative to the first differential signal hole 100a. The specific angle of the included angle is not restricted in the present embodiment, and the included angle shall be greater than zero and less than 90 degrees. In an exemplary embodiment, in order to ensure the wiring tightness of the circuit board, the included angle is greater than zero and less than 5 degrees. In addition, when the second differential signal hole 100b is set at a tilt relative to the first differential signal hole 100a, the tilt direction is similarly not restricted in the present embodiment. In an exemplary embodiment, in the sectional view of the circuit board, the second differential signal hole 100b may be set leftwards at a tilt relative to the first differential signal hole 100a, or the second differential signal hole 100b may be set rightwards at a tilt relative to the first differential signal hole 100a.

In some embodiments, the second differential signal hole 100b is a through hole provided in the thickness direction of the circuit board, the first differential signal hole 100a is a through hole provided in the circuit board in a second direction, and there is a certain included angle between the second direction and the thickness direction of the circuit board. Therefore, in the sectional view of the circuit board, the second differential signal hole 100b is set vertically, and the first differential signal hole 100a is set at a tilt relative to the second differential signal hole 100b. The specific angle of the included angle is not restricted in the present embodiment, and the included angle shall be greater than zero and less than 90 degrees. In an exemplary embodiment, in order to ensure the wiring tightness of the circuit board, the included angle is greater than zero and less than 5 degrees. In addition, when the first differential signal hole 100a is set at a tilt relative to the second differential signal hole 100b, the tilt direction is similarly not restricted in the present embodiment. In an exemplary embodiment, in the sectional view of the circuit board, the first differential signal hole 100a may be set leftwards at a tilt relative to the second differential signal hole 100b, or the first differential signal hole 100a may be set rightwards at a tilt relative to the second differential signal hole 100b.

In some embodiments, in the sectional view of the circuit board, the first differential signal hole 100a and the second differential signal hole 100b are both provided at a tilt. In an exemplary embodiment, tilt angles of the first differential signal hole 100a and the second differential signal hole 100b are different; or the tilt angles of the first differential signal hole 100a and the second differential signal hole 100b are the same, but tilt directions of the first differential signal hole 100a and the second differential signal hole 100b are different.

Referring to FIG. 1 and FIG. 2, in some embodiments, the first differential signal hole 100a is a through hole provided in the thickness direction of the circuit board, the second differential signal hole 100b includes at least two second signal aperture segments communicated with each other in the thickness direction of the circuit board, and at least one of the second signal aperture segments has a step-like change in a horizontal direction compared with other second signal aperture segments. It should be noted that the step-like change refers to the form of up-down staggered setting of the second signal aperture segment showing changes compared with other second signal aperture segments, that is, the central axis of the second signal aperture segment showing changes does not coincide with the central axis of other second signal aperture segments, at this time, the central axis of the second differential signal hole 100b includes a central axis of each second signal aperture segment, and the distance between the central axis of the first differential signal hole 100a and the central axis of the second differential signal hole 100b is the distance between the first differential signal hole 100a and the central axis of the adjacent second signal aperture segment in the horizontal direction. Since at least one second signal aperture segment has a step-like change compared with other second signal aperture segments, the distance between the central axis of the first differential signal hole 100a and the central axis of the second signal aperture segment showing changes is different from the distance between the first differential signal hole 100a and other second signal aperture segments. In addition, for the convenience of description, the present embodiment takes the example of providing two second signal aperture segments on the second differential signal hole 100b in the thickness direction of the circuit board for detailed description, and moreover, for the convenience of description, the two second signal aperture segments are respectively called a third signal segment 110b and a fourth signal segment 120b. In an exemplary embodiment, in the sectional view of the circuit board, the third signal segment 110b is located above the fourth signal segment 120b, and the central axis C-C of the third signal segment 110b is staggered from the central axis D-D of the fourth signal segment 120b in the horizontal direction. At this time, the distance between the central axis of the first differential signal hole 100a and the central axis C-C of the third signal segment 110b is LSS1, and the distance between the central axis of the first differential signal hole 100a and the central axis D-D of the fourth signal segment 120b is LSS2, so LSS1 is not equal to LSS2, thereby adjusting the mutual capacitance and mutual induction of the differential signal holes, and thus adjusting the impedance of the differential signal holes.

In an exemplary embodiment, one of the third signal segment 110b and the fourth signal segment 120b is a through hole provided in the thickness direction of the circuit board, the other is a through hole provided at a tilt in a third direction, and there is an included angle between the third direction and the thickness direction of the circuit board.

In an exemplary embodiment, the third signal segment 110b and the fourth signal segment 120b are both through holes provided in the thickness direction of the circuit board.

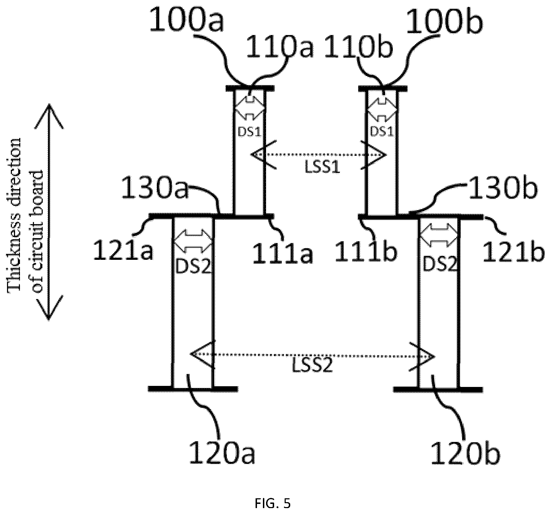

Referring to FIG. 1 and FIG. 5, in an exemplary embodiment, an aperture DS1 of the third signal segment 110b and an aperture DS2 of the fourth signal segment are not restricted in the present embodiment. In an exemplary embodiment, the aperture DS1 of the third signal segment 110b may be equal to the aperture DS2 of the fourth signal segment 120b; or the aperture DS1 of the third signal segment 110b is greater than the aperture DS2 of the fourth signal segment 120b; or the aperture DS1 of the third signal segment 110b is less than the aperture DS2 of the fourth signal segment 120b. In an exemplary embodiment, an absolute value of the difference between the apertures of two first signal aperture segments with different apertures is ≥ 0.001 mm, that is, when the aperture of the third signal segment 110b is greater than the aperture of the fourth signal segment 120b, the aperture of the third signal segment 110b is greater than the aperture of the fourth signal segment 120b by a first predetermined distance, and a minimum value of the first predetermined distance is 0.001 mm. In order to facilitate processing and preparation, the first predetermined distance may be 0.005 mm or 0.025 mm, etc. When the aperture of the third signal segment 110b is less than the aperture of the fourth signal segment 120b, the aperture of the third signal segment 110b is less than the aperture of the fourth signal segment 120b by a second predetermined distance, and a minimum value of the second predetermined distance is 0.001 mm. In order to facilitate processing and preparation, the first predetermined distance may be 0.005 mm or 0.025 mm.

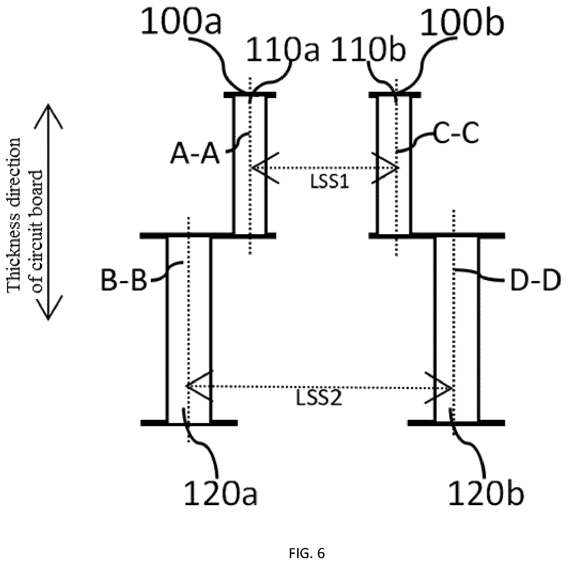

In combination with FIG. 2 and FIG. 6, in the thickness direction of the circuit board, the center distances between the first signal aperture segment and the second signal aperture segment are completely the same, partially the same or completely different, and an absolute value of the difference between the different center distances is ≥ 0.001 mm when the center distances are partially the same or completely different. Similarly, an optimal combined value of the aperture of the third signal segment 110b and the aperture of the fourth signal segment 120b can be obtained by simulation or testing. An optimal combined value of the distance between the central axis of the third signal segment 110b and the central axis of the first differential signal hole 100a and the distance between the central axis of the fourth signal segment 120b and the first differential signal hole 100a can be obtained by simulation or testing.

In addition, it should be noted that when the second differential signal hole 100b is provided with three second signal aperture segments or even more second signal aperture segments in the thickness direction of the circuit board, other second signal aperture segments may all have the same structure as the third signal segment 110b, or all have the same structure as the fourth signal segment 120b, or partially have the same structure as the third signal segment 110b and partially have the same structure as the fourth signal segment 120b, or have a structure different from the structure of the third signal segment 110b and the fourth signal segment 120b. In addition, other second signal aperture segments may be completely the same in structure, completely different in structure or partially the same in structure. In addition, when three or more second signal aperture segments are provided, the third signal segment 110b and the fourth signal segment 120b referred to above in the plurality of second signal aperture segments are not limited to the first and second counted from top to bottom in a height direction of the circuit board, and may be any two adjacent to each other or any two not adjacent to each other. Therefore, as long as there is a structure in which the center distance between the second differential signal hole 100b and the first differential signal hole 100a changes in the thickness direction of the circuit board, it should be within the scope of protection of the present disclosure.

Referring to FIG. 1 and FIG. 5, in some embodiments, the second differential signal hole 100b is a through hole provided in the thickness direction of the circuit board, the first differential signal hole 100a includes at least two first signal aperture segments communicated with each other in the thickness direction of the circuit board, and at least one of the first signal aperture segments has a step-like change in the horizontal direction compared with other first signal aperture segments. It should be noted that the step-like change refers to the form of up-down staggered setting of the second signal aperture segment showing changes compared with other second signal aperture segments, that is, the central axis of the second signal aperture segment showing changes does not coincide with the central axis of other second signal aperture segments, at this time, the central axis of the second differential signal hole 100b includes a central axis of each second signal aperture segment, and the distance between the central axis of the first differential signal hole 100a and the central axis of the second differential signal hole 100b is the distance between the central axis of the first differential signal hole 100a and the central axis of the adjacent second signal aperture segment in the horizontal direction. Since at least one second signal aperture segment has a step-like change compared with other second signal aperture segments, the distance between the central axis of the first differential signal hole 100a and the central axis of the second signal aperture segment showing changes is different from the distance between the first differential signal hole 100a and other second signal aperture segments. In addition, for the convenience of description, the present embodiment takes the example of providing two first signal aperture segments on the first differential signal hole 100a in the thickness direction of the circuit board for detailed description, and moreover, for the convenience of description, the two first signal aperture segments are respectively called a first signal segment 110a and a second signal segment 120a. In this case of setting, the specific structure of the first differential signal hole 100a may be the same as the above-mentioned structure in which the first differential signal hole 100a is a through hole provided in the thickness direction of the circuit board and the aperture of the second differential signal hole 100b has a step-like change. That is, the structure change of the first signal segment 110a is similar to that of the third signal segment 110b, and the structure change of the second signal segment 120a is similar to that of the fourth signal segment 120b, so it will not be repeated in the present embodiment.

In some embodiments, at least one of the first signal aperture segments is set in a step shape compared with other first signal aperture segments, and at least one of the second signal aperture segments is set in a step shape compared with other second signal aperture segments.

In an exemplary embodiment, the first signal aperture segments and/or the second signal aperture segments are set in a step shape in the thickness direction of the circuit board, that is, the upper and lower parts of the first differential signal hole 100a are staggered, that is, the central axes of the upper and lower parts of the first differential signal hole 100a are staggered from each other. In this case, there are a plurality of central axes of the first differential signal hole 100a according to the number of step-like changing structures presented, and the central axis of the first differential signal hole 100a referred to herein refers to all the central axes thereof. In the distance between the central axis of the second differential signal hole 100b and the central axis of the first differential signal hole 100a, the central axis of the first differential signal hole 100a refers to the central axis of the corresponding part of the first differential signal hole 100a that is located in the same horizontal direction, namely a left and right direction shown in the figure, as the second differential signal hole 100b. Similarly, the second signal aperture segments are set in a step shape in the thickness direction of the circuit board, which means that the upper and lower parts of the second differential signal hole 100b are staggered, that is, the central axes of the upper and lower parts of the second differential signal hole 100b are staggered from each other. In this case, there are a plurality of central axes of the second differential signal hole 100b according to the number of step-like changing structures presented, and the central axis of the second differential signal hole 100b referred to herein refers to all the central axes thereof. In the distance between the central axis of the first differential signal hole 100a and the central axis of the second differential signal hole 100b, the central axis of the second differential signal hole 100b refers to the central axis of the corresponding part of the second differential signal hole 100b that is located in the same horizontal direction, namely the left and right direction shown in the figure, as the first differential signal hole 100a.

In an exemplary embodiment, the apertures of the first signal aperture segment and the second signal aperture segment located in the same horizontal direction are the same. Similarly, the aperture of the first signal aperture segment located in the same horizontal direction may also be different from the aperture of the second signal aperture segment. However, for the purpose of structural consistency, the structure in which the first signal aperture segment and the second signal aperture segment located in the same horizontal direction have the same aperture is adopted in the present disclosure.

In an exemplary embodiment, the first differential signal hole 100a and the second differential signal hole 100b are arranged symmetrically in the thickness direction of the circuit board to make the via hole structure have structural consistency.

In combination with FIG. 2 and FIG. 6, it should be noted that the structure required set forth in the present disclosure shall also include the case that the first differential signal hole 100a and the second differential signal hole 100b are asymmetrical in the thickness direction of the circuit board. For the convenience of description, the case that the first differential signal hole 100a includes two first signal aperture segments, the two first signal aperture segments are a first signal segment 110a and a second signal segment 120a respectively, the second differential signal hole 100b includes two second signal aperture segments, and the two second signal aperture segments are a third signal segment 110b and a fourth signal segment 120b respectively is taken as an example for detailed description. In an exemplary embodiment, when the central axis B-B of the second signal segment 120a moves leftwards relative to the central axis A-A of the first signal segment 110a, at this time, the central axis D-D of the fourth signal segment 120b can move leftwards relative to the central axis C-C of the third signal segment 110b. It is only necessary to note that a moving distance of the fourth signal segment 120b is different from that of the third signal segment 110b. In addition, in this case, the central axis D-D of the fourth signal segment 120b may also move rightwards relative to the central axis C-C of the third signal segment 110b, and at this time, the moving distance is not limited. In addition, when the central axis B-B of the second signal segment 120a may also move rightwards relative to the central axis A-A of the first signal segment 110a, at this time, the central axis D-D of the fourth signal segment 120b may move rightwards relative to the central axis C-C of the third signal segment 110b. It is only necessary to note that the moving distance of the fourth signal segment 120b is different from that of the third signal segment 110b. In addition, in this case, the central axis D-D of the fourth signal segment 120b may further move leftwards relative to the central axis C-C of the third signal segment 110b, and at this time, the moving distance is not limited.

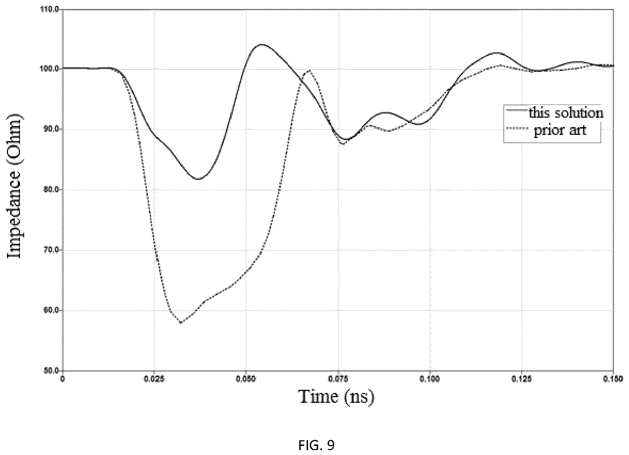

Referring to FIG. 1 and FIG. 5, in an exemplary embodiment, when the first differential signal hole 100a and the second differential signal hole 100b both have a step-like change, the apertures of the first signal aperture segment and the second signal aperture segment located in the same horizontal direction may be the same or different. For the convenience of description, the case that the first differential signal hole 100a includes a first signal segment 110a and a second signal segment 120a, and the second differential signal hole 100b includes a third signal segment 110b and a fourth signal segment 120b is taken as an example for description. At this time, the center distance between the first signal segment 110a and the third signal segment 110b is LSS1, and the center distance between the second signal segment 120a and the fourth signal segment 120b is LSS2. When LSS2 is less than LSS1, in combination with FIG. 9, it can be seen that the parasitic capacitance of the differential signal holes decreases and the parasitic inductance increases, thereby increasing the impedance of the differential signal holes. At the same time, the simultaneous adjustment of the apertures of the differential signal holes will also change the parasitic capacitance of the differential signal holes. In a case of the simultaneous adjustment of the apertures of the differential signal holes and the center distance between the first differential signal hole 100a and the second differential signal hole 100b, routing of other signals can be facilitated, and the wiring density is improved.

In addition, it should be noted that the center distance between the first differential signal hole 100a and the second differential signal hole 100b and the apertures of the differential signal holes can be adjusted in the structure of the same layer of the circuit board, and likewise can be adjusted in the structure of different layers of the circuit board.

Referring to FIG. 1 and FIG. 5, in some embodiments, the circuit board is provided with a wire outlet layer in the thickness direction of the circuit board, and the first differential signal hole 100a and/or the second differential signal hole 100b both have a step change at the wire outlet layer. That is, when the first differential signal hole 100a includes a plurality of first signal aperture segments, and at least one of the first signal aperture segments has a step change, the part of the first signal aperture segment located in the wire outlet layer has a structure change, and two adjacent first signal aperture segments that have a step change are connected through a first conductor 130a. In an exemplary embodiment, a first pad 111a of the first signal segment 110a is connected to a second pad 121a of the second signal segment 120a through the first conductor 130a.

In addition, when the second differential signal hole 100b includes a plurality of second signal aperture segments, and at least one of the second signal aperture segments has a step change, the part of the second signal aperture segment located in the wire outlet layer has a structure change, and two adjacent second signal aperture segments that have a step change are connected through a second conductor 130b. In an exemplary embodiment, a third pad 111b of the third signal segment 110b is connected to a fourth pad 121b of the fourth signal segment 120b through the second conductor 130b.

Similarly, when the first differential signal hole 100a and the second differential signal hole 100b are set in a step-shaped structure at the same time, the principle is similar to the structure change described above, so it is not repeated in the present embodiment. In addition, the optimal combined value of the first conductor 130a and the second conductor 130b can be obtained by simulation or testing.

In some embodiments, the via hole structure may further include a plurality of pairs of differential signal holes. When the plurality of pairs of differential signal holes are provided, the structure change is similar to the structure change of one pair of differential signal holes, so it will not be repeated in the present embodiment.

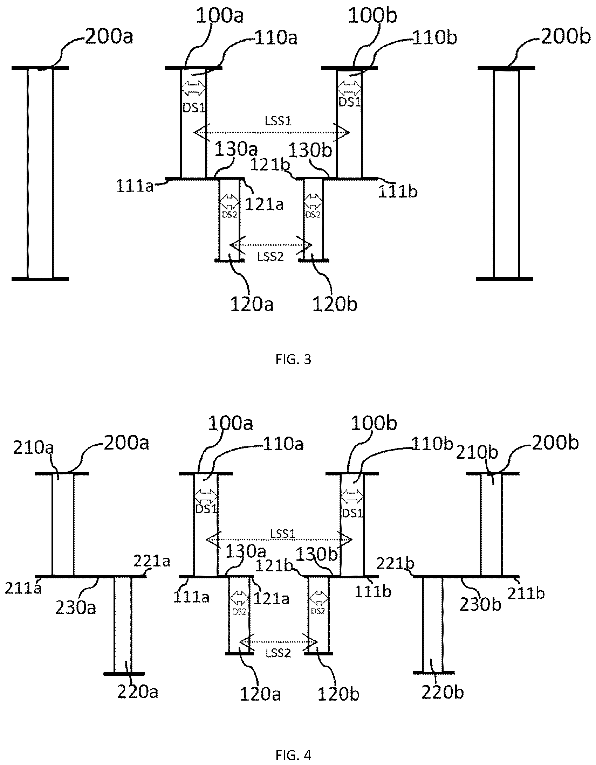

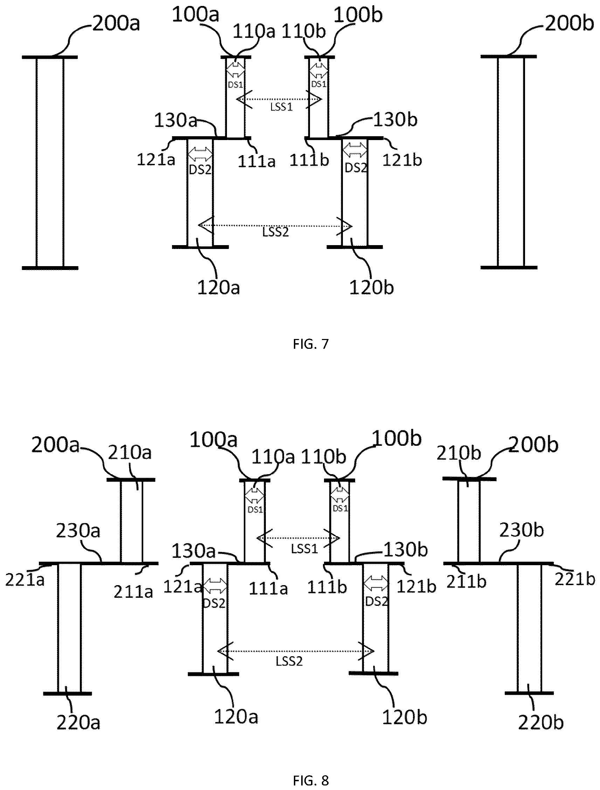

Referring to FIG. 3 and FIG. 7, in some embodiments, at least two ground via holes are configured around each pair of differential signal holes. In an exemplary embodiment, two ground via holes are configured around each pair of differential signal holes. Similarly, according to different application scenarios and requirements, three or more ground via holes may also be configured around each pair of differential signal holes. For the convenience of description, in the present disclosure, the case that two differential signal holes are configured around each pair of differential signal holes is taken as an example for detailed explanation, and the two ground via holes are a first ground via hole 200a and a second ground via hole 200b respectively.

In combination with FIG. 4 and FIG. 8, in an exemplary embodiment, a length between the central axis of the first differential signal hole 100a and the central axis of the adjacent ground via hole is equal in the thickness direction of the circuit board. That is, the specific structure of the ground via hole adjacent to the first differential signal hole 100a changes according to the change in the structure of the first differential signal hole 100a. In an exemplary embodiment, when the first differential signal hole 100a is set in a step shape, the ground via hole adjacent to the first differential signal hole 100a is the first ground via hole 200a, in order to ensure that the center distance between the first differential signal hole 100a and the first ground via hole 200a is the same everywhere in the thickness direction of the circuit board, the first ground via hole 200a is also of a step-shaped structure, so as to ensure the structure consistency.

In an exemplary embodiment, the first ground via hole 200a is divided into a first ground via segment 210a and a second ground via segment 220a in the thickness direction of the circuit board. It should be noted that the detailed description at this time is performed according to the example of the first differential signal hole 100a divided into two segments in the thickness of the circuit board. In the actual processing and preparation, the first ground via hole 200a may also have a structure arrangement of being divided into a plurality of segments in the thickness direction of the circuit board. The first ground via segment 210a is located on the upper part, the second ground via segment 220a is located on the lower part and communicated with the first ground via segment 210a, and a fifth pad 211a of the first ground via segment 210a and a sixth pad 221a of the second ground via segment 220a are communicated through a third conductor 230a.

Similarly, the length between the central axis of the second differential signal hole 100b and the central axis of the adjacent ground via hole is equal in the thickness direction of the circuit board, so as to ensure the structure consistency. That is, the ground via hole adjacent to the second differential signal hole 100b is the second ground via hole 200b, and when the structure of the second differential signal hole 100b is in a step shape, the structure of the second ground via hole 200b is also in a step shape.

In an exemplary embodiment, the second ground via hole 200b is divided into a third ground via segment 210b and a fourth ground via segment 220b in the thickness direction of the circuit board. It should be noted that the detailed description at this time is performed according to the example of the second differential signal hole 100b divided into two segments in the thickness of the circuit board. In the actual processing and preparation, the second ground via hole 200b may also have a structure arrangement of being divided into a plurality of segments in the thickness direction of the circuit board. The third ground via segment 210b is located on the upper part, the fourth ground via segment 220b is located on the lower part and communicated with the third ground via segment 210b, and a seventh pad 211b of the third ground via segment 210b and an eighth pad 221b of the fourth ground via segment 220b are communicated through a fourth conductor 230b.

### Embodiment 2

The present embodiment further provides a circuit board. The circuit board includes the via hole structure of the circuit board according to the above-mentioned embodiment. The circuit board is used to implement the above embodiments and preferred implementations, and will not be repeated where it has already been described.

Referring to FIG. 3 and FIG. 4, in some embodiments, differential signal holes are connected with a high-speed connector, and the high-speed connector is crimped to the differential signal holes. Due to own reasons, an existing high-speed connector has a large crimping aperture, about 0.3 mm, resulting in a large center distance between differential via holes of an existing circuit board, about 1.2 mm. Generally, it needs to ensure the impedance of the crimping differential signal holes to be between 80-85 ohm, but for a 100-ohm system, there will be a case of impedance discontinuity, and thus the transmission quality of differential signals in the system is affected, resulting in a low bandwidth of the differential signals.

In an exemplary embodiment, the center distance LSS2 between a second signal segment 120a and a fourth signal segment 120b is less than the center distance LSS1 between a first signal segment 110a and a third signal segment 110b, the mutual capacitance of the differential signal holes is decreased, the mutual induction of the differential signal holes is increased, and accordingly the impedance of the differential signal holes is improved. In an exemplary embodiment, on the basis of the foregoing arrangement, the aperture of the second signal segment 120a is less than the aperture of the first signal segment 110a, and the aperture of the fourth signal segment 120b is less than the aperture of the third signal segment 110b, thereby further increasing the impedance to ensure the impedance continuity of a system link and improve the propagation quality of the differential signal holes.

Referring to FIG. 7 and FIG. 8, in some embodiments, the differential signal holes are connected with a BGA chip. In the prior art, with the increase of the signal rate, the center distance between the differential signal holes of a ball grid array (BGA) gradually decreases, and it is even possible that the center distance between the differential signal holes is only 0.6 mm, and the aperture of fan out holes of the BGA is mostly about 0.2 mm, resulting in difficult processing of differential transmission lines in the BGA, the impedance of the differential signal holes is high and may be 110 to 120 ohm, and if the system impedance is discontinuous for 90 ohm, it will increase the discontinuity in the system link and affect the signal quality. In common products, in order to ensure the signal quality, the first few layers are generally power layers, the fan out holes of the BGA generally use back pads to eliminate its impact on the signal quality, and when the center distance between the differential signal holes of the BGA is small, it will cause a number of suspended copper sheets, affecting the quality of the power flow and high-speed signals.

In an exemplary embodiment, the center distance LSS2 between the second signal segment 120a and the fourth signal segment 120b is greater than the center distance LSS1 between the first signal segment 110a and the third signal segment 110b, the mutual capacitance of the differential signal holes is increased, the mutual induction of the differential signal holes is decreased, and accordingly the impedance of the differential signal holes is decreased. In an exemplary embodiment, on the basis of the foregoing arrangement, the aperture of the second signal segment 120a is greater than the aperture of the first signal segment 110a, and the aperture of the fourth signal segment 120b is greater than the aperture of the third signal segment 110b, thereby further decreasing the impedance to ensure the impedance continuity of the system link and improve the propagation quality of the differential signal holes.

In addition, when the center distance between the differential signal holes in the prior art is 1 mm, the bandwidth is low, and it is difficult to meet the bandwidth demand of 224 GbpsPAM4. In this case, the circuit board may have a case that a differential line penetrates through a pad at a certain wire outlet layer, which will cause large crosstalk and affect the quality of the high-speed signals.

In an exemplary embodiment, the center distance LSS2 between the second signal segment 120a and the fourth signal segment 120b is less than the center distance LSS1 between the first signal segment 110a and the third signal segment 110b, the mutual capacitance of the differential signal holes is decreased, the mutual induction of the differential signal holes is increased, and accordingly the impedance of the differential signal holes is improved. In an exemplary embodiment, on the basis of the foregoing arrangement, the aperture of the second signal segment 120a is greater than the aperture of the first signal segment 110a, and the aperture of the fourth signal segment 120b is greater than the aperture of the third signal segment 110b, thereby improving the bandwidth of the differential signal holes and ensure the propagation quality of the system link.

Through the present disclosure, due to the fact that the distance between the central axis of the first differential signal hole and the central axis of the second signal hole is different at different heights, the mutual capacitance can be increased or decreased by changing the distance between the central axis of the first differential signal hole and the central axis of the second differential signal hole, thereby decreasing or increasing the impedance of the differential signal holes. Furthermore, the problem of poor impedance continuity in multi-layer circuit boards is solved, and the integrity of product signals is guaranteed. Through the present disclosure, the impedance of the differential signal holes can be increased or decreased, the problem of poor impedance continuity in the multi-layer circuit boards can be solved, and the effect of improving the impedance continuity of the via hole is achieved.

The foregoing descriptions are only preferred embodiments of the present disclosure and are not used to limit the present disclosure. For those skilled in the art, the present disclosure can have various modifications and changes. Any modification, equivalent replacement, improvement, etc. made within the principle of the present disclosure should be included in the scope of protection of the present disclosure.

## Claims

1. A via hole structure of a circuit board, comprising at least one pair of differential signal holes, wherein each pair of differential signal holes comprises a first differential signal hole and a second differential signal hole; and
in a thickness direction of the circuit board, there are several distances between a central axis of the first differential signal hole and a central axis of the second differential signal hole, and numerical values of at least two distances are different.

2. The via hole structure according to claim 1, wherein the first differential signal hole comprises at least two first signal aperture segments communicated with each other in the thickness direction of the circuit board, and the second differential signal hole comprises at least two second signal aperture segments communicated with each other in the thickness direction of the circuit board.

3. The via hole structure according to claim 2, wherein the first signal aperture segments and/or the second signal aperture segments are set in a step shape in the thickness direction of the circuit board.

4. The via hole structure according to any one of claims 1 to 3, wherein apertures of the first signal aperture segment and the second signal aperture segment located in the same horizontal direction are the same.

5. The via hole structure according to claim 4, wherein the first differential signal hole and the second differential signal hole are arranged symmetrically in the thickness direction of the circuit board.

6. The via hole structure according to claim 2, wherein an aperture of each first signal aperture segment is completely the same, partially the same or completely different; and an aperture of each second signal aperture segment is completely the same, partially the same or completely different.

7. The via hole structure according to claim 6, wherein when the aperture of each first signal aperture segment is partially the same or completely different, an absolute value of a difference between the apertures of two first signal aperture segments with different apertures is ≥ 0.001 mm; and when the aperture of each second signal aperture segment is partially the same or completely different, an absolute value of a difference between the apertures of two second signal aperture segments with different apertures is ≥ 0.001 mm.

8. The via hole structure according to claim 6, wherein in the thickness direction of the circuit board, center distances between the first signal aperture segments and the second signal aperture segments are completely the same, partially the same or completely different, and an absolute value of a difference between the different center distances is ≥ 0.001 mm when the center distances are partially the same or completely different.

9. The via hole structure according to claim 1, wherein at least two ground via holes are configured around each pair of differential signal holes.

10. The via hole structure according to claim 9, wherein a length between the central axis of the first differential signal hole and a central axis of the adjacent ground via hole is equal in the thickness direction of the circuit board.

11. The via hole structure according to claim 9 or 10, wherein a length between the central axis of the second differential signal hole and a central axis of the adjacent ground via hole is equal in the thickness direction of the circuit board.

12. A circuit board, comprising the via hole structure of the circuit board according to any one of claims 1 to 11.
